(19) Europäisches Patentamt
European Patent Office
Office européen des brevets

(11) EP 0 621 697 B1

(12) FASCICULE DE BREVET EUROPEEN

(45) Date de publication et mention
de la délivrance du brevet:
**12.08.1998  Bulletin 1998/33**

(51) Int Cl.⁶: **H03L 7/199**, H03L 7/10

(21) Numéro de dépôt: **94400837.4**

(22) Date de dépôt: **18.04.1994**

(54) **Procédé pour accélérer la synchronisation d'une boucle à verrouillage de phase et boucle correspondante**

Verfahren zur Beschleunigung der Synchronisierung einer Phasenregelschleife und entsprechende Phasenregelschleife

Process for accelerating the synchronisation of a phase locked loop and corresponding loop

(84) Etats contractants désignés:
**DE GB**

(30) Priorité: **20.04.1993  FR 9304609**

(43) Date de publication de la demande:
**26.10.1994  Bulletin 1994/43**

(73) Titulaire: **FRANCE TELECOM**
**75015 Paris (FR)**

(72) Inventeur: **Bouvier, Jacky**
**F-38240 Meylan (FR)**

(74) Mandataire: **Casalonga, Axel**
**BUREAU D.A. CASALONGA - JOSSE**
**Morassistrasse 8**
**80469 München (DE)**

(56) Documents cités:
**EP-A- 0 012 899        EP-A- 0 258 042**
**EP-A- 0 389 894        DE-A- 2 932 049**
**US-A- 4 843 469**

## Description

L'invention concerne les boucles à verrouillage de phase, notamment celles comportant comme oscillateur à fréquence variable commandé en tension, un oscillateur à quartz.

Une boucle à verrouillage de phase comporte classiquement un comparateur de phase dont les deux entrées reçoivent respectivement un signal externe faisant généralement office de signal synchronisant, et un signal interne à synchroniser, issu du signal de sortie de l'oscillateur commandé en tension. Le comparateur de phase est par ailleurs rebouclé en sortie sur cet oscillateur par l'intermédiaire d'un filtre. Une telle boucle à verrouillage de phase s'active à la coïncidence des transitions entre le signal synchronisant et le signal à synchroniser.

EP-A-0 258 042 décrit une boucle à verrouillage de phase comportant un oscillateur suivi d'un diviseur de fréquence connecté à l'une des entrées du comparateur de phase dont l'autre entrée reçoit le signal de référence. Lorsque la sortie du comparateur de phase est représentative d'une non coïncidence de phase entre le signal de référence et le signal issu du diviseur de fréquence, le comparateur de phase est inhibé et le diviseur de fréquence est ré-initialisé de façon à obtenir une coïncidence des transistors entre le signal de sortie de ce diviseur de fréquence et le signal de référence.

US-A-4 843 469 décrit une boucle à verrouillage de phase comportant un oscillateur relié en sortie à un compteur alimentant un comparateur de phase recevant par ailleurs un signal de synchronisation. La boucle comporte également un circuit de détection de verrouillage recevant le signal de synchronisation et capable, lorsque le front montant du signal de synchronisation se situe en dehors d'une fenêtre logique, de générer un signal de commande apte à ré-initialiser le compteur.

Le but général de l'invention est de favoriser l'activation d'une boucle à verrouillage de phase en accélérant la synchronisation des deux signaux externe et interne.

L'invention s'applique d'une façon particulièrement avantageuse aux boucles à verrouillage de phase comportant un oscillateur à quartz, dont les variations de fréquence sont typiquement de l'ordre de ± 100 ppM, et devant être synchronisé sur un signal externe ayant une fréquence sous-multiple de la fréquence nominale de l'oscillateur à quartz dans un rapport de l'ordre de 1000 ou plus. En effet, à la mise sous tension de la boucle, lors de l'apparition des deux signaux à synchroniser, à savoir le signal externe et le signal issu du diviseur placé entre le comparateur de phase et l'oscillateur, les transitions de ces deux signaux se produisent à des instants aléatoires et la première coïncidence peut se produire selon le cas, plus d'une seconde après la mise sous tension. L'invention a alors pour but de forcer la première coïncidence dans un délai au plus égal à deux périodes du signal externe, ou synchronisant.

L'invention a encore plus but de réaliser cet objectif à partir essentiellement d'éléments logiques.

Telle que revendiquée l'invention a donc tout d'abord pour objet un procédé pour favoriser l'activation d'une boucle à verrouillage de phase, dans lequel :

a) on compare la phase du signal externe reçu et celle du signal interne tiré du signal de sortie de l'oscillateur commandé en tension de la boucle, et
b) en réponse à une indication prédéterminée représentative d'une non coïncidence de phase entre les deux signaux, on modifie la phase du signal interne afin de forcer la mise sensiblement en phase de celui-ci avec le signal externe. Selon l'invention, afin notamment de ne pas perturber le fonctionnement de la boucle à verrouillage de phase, après avoir forcé la mise en phase des deux signaux à synchroniser, on inhibe toute action sur les moyens de génération, tels que le diviseur, du signal interne pendant une durée prédéterminée, même en présence d'une autre indication représentative d'une non coïncidence de phase entre les deux signaux, et on répète ensuite l'étape b) en présence d'une nouvelle indication prédéterminée.

Selon un mode de mise en oeuvre du procédé selon l'invention, dans lequel la boucle comporte un diviseur relié à la sortie de l'oscillateur commandé en tension et apte à délivrer ledit signal interne, on réinitialise le diviseur, en présence de ladite indication prédéterminée, pour forcer une quasi coïncidence entre une transition du signal interne et une transition du signal externe.

Selon un mode de mise en oeuvre du procédé, on fait délivrer au comparateur de phase un signal de non coïncidence, représentatif d'une non coïncidence de phase entre les deux signaux, et l'on filtre le signal de non coïncidence, ladite indication prédéterminée étant alors la valeur de ce signal de non coïncidence filtré. Il est ainsi possible de filtrer les brèves transitions parasites qui peuvent se produire même si les deux signaux sont en phase.

Selon un mode préféré de mise en oeuvre du procédé, on agit sur les moyens de génération du signal interne dans un délai au plus égal à sensiblement deux périodes du signal externe tandis que l'on filtre tout signal de non coïncidence ayant une durée inférieure à une période du signal d'horloge de l'oscillateur commandé en tension.

Telle que revendiquée l'invention a également pour objet une boucle à verrouillage de phase, comportant des moyens de génération d'un signal interne tiré du signal de sortie de l'oscillateur commandé en tension, et un comparateur de phase apte à comparer la phase du signal interne avec celle d'un signal externe reçu, la sortie du comparateur étant rebouclée sur l'oscillateur commandé en tension. La boucle comprend en outre un dispositif accélérateur de la synchronisation des signaux interne et externe, comportant des moyens de traitement aptes à recevoir du comparateur de phase une indication prédéterminée représentative de la non coïncidence des signaux interne et externe, et à délivrer, en réponse à cette indication prédéterminée, une information de commande en réponse à laquelle les moyens de génération modifient la phase du signal interne pour forcer sa mise sensiblement en phase avec le signal externe. Selon l'invention les moyens de traitement possèdent un état de repos en l'absence d'indication prédéterminée émanant du comparateur, un état actif dans lequel, en présence d'une indication prédéterminée émanant du comparateur de phase, ils délivrent ladite information de commande au moyen de génération du signal interne, et un état de temporisation dans lequel ils sont inactifs vis-à-vis de la commande des moyens de génération, même en présence d'une nouvelle indication prédéterminée émanant du comparateur de phase. Le dispositif comporte par ailleurs des moyens de séquencement aptes à faire passer les moyens de traitement de leur état de repos à leur état actif puis à leur état de temporisation et à leur état de repos au rythme des transitions du signal externe.

Selon un mode de réalisation dans lequel les moyens de génération comportent un diviseur disposé entre la sortie de l'oscillateur commandé en tension et une entrée du comparateur de phase, ce diviseur délivrant ledit signal interne formé d'une succession périodique de transitions, l'information de commande est un signal de commande d'initialisation du diviseur émis sensiblement en coïncidence avec une transition du signal externe, le diviseur émettant en réponse une transition de signal interne sensiblement coïncidente avec ladite transition de signal externe.

Selon un mode de réalisation de l'invention, les moyens de traitement comportent :

- un compteur séquenceur, séquencé au rythme des transitions du signal externe, et susceptible de délivrer cycliquement un jeu de valeurs de comptage différentes associées aux différents états des moyens de traitement,
- un premier ensemble logique relié à la sortie du compteur, et susceptible de délivrer une impulsion de commande en réponse à une valeur de comptage prédéterminée associée à l'état de travail,
- un deuxième ensemble logique, relié d'une part à la sortie du premier ensemble logique, et d'autre part à l'entrée de signal externe, pour délivrer, en réponse à ladite impulsion de commande, ladite information de commande sensiblement en coïncidence avec une transition du signal externe.

Le comparateur de phase est avantageusement susceptible de délivrer un signal de non coïncidence de phase des signaux interne et externe et le dispositif comporte alors de préférence un filtre apte à filtrer les signaux de non coïncidence ayant une durée inférieure à une durée prédéterminée, ladite indication prédéterminée étant la valeur du signal de non coïncidence filtré.

L'invention a également pour objet un dispositif d'accélération de la synchronisation des signaux interne et externe d'une boucle à verrouillage de phase du type de celle qui vient d'être évoquée.

D'autres avantages et caractéristiques de l'invention apparaîtront à l'examen de la description détaillée d'un mode de réalisation nullement limitatif de l'invention, illustré sur les dessins annexés sur lesquels :

- la figure 1 est une représentation schématique d'une boucle à verrouillage de phase équipée d'un dispositif selon l'invention,
- la figure 2 est un synoptique schématique plus détaillé du dispositif de la figure 1, et
- les figures 3 et 4 représentent des chronogrammes temporels relatifs au fonctionnement du dispositif de la figure 2.

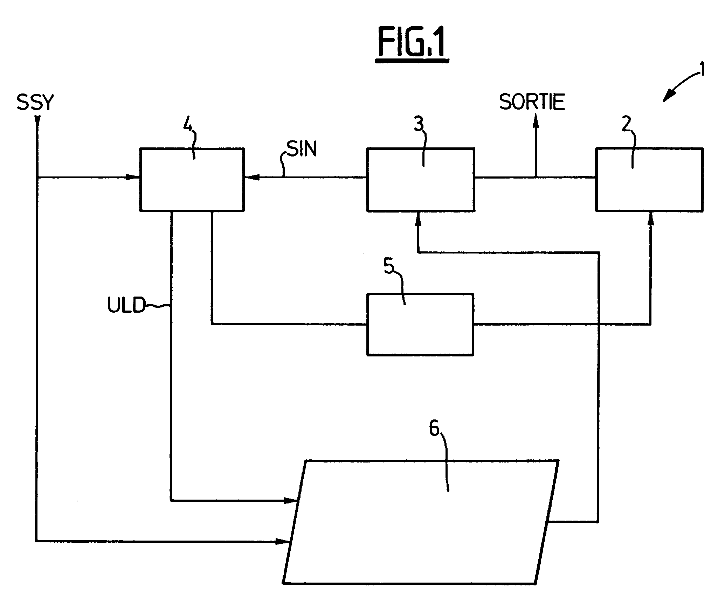

Telle qu'elle est illustrée sur la figure 1, la boucle à verrouillage de phase 1 comporte un oscillateur 2 à quartz à fréquence variable commandé en tension. La sortie de cet oscillateur, qui est également la sortie de la boucle à verrouillage de phase, est par ailleurs reliée à l'entrée d'un diviseur 3 de grande valeur, dont la sortie est reliée à l'une des entrées du comparateur de phase 4 de la boucle. L'autre entrée de ce comparateur de phase est reliée à une entrée de signal externe SSY qui agit ici comme signal synchronisant. La sortie du comparateur de phase est rebouclée sur l'oscillateur 2 par l'intermédiaire d'un filtre 5.

Dans le cas par exemple d'un oscillateur 2 centré sur une fréquence de 27 000 kHz et devant être synchronisé sur un signal externe synchronisant SSY ayant une fréquence de 15,625 kHz, le facteur N de division du diviseur 3 est alors de 1728. Si l'on suppose que cet oscillateur 2 a une variation de fréquence $\Delta f$ de l'ordre de $\pm 2$ kHz, la fréquence de glissement du signal synchronisant SSY par rapport au signal à synchroniser SIN, issu du diviseur 3, est égal au rapport $\Delta f/N$ soit 1,15 Hz ce qui correspond à une période de l'ordre de 0,87 seconde qui peut s'avérer être dans un cas défavorable, le délai avant synchronisation des deux signaux et donc avant activation de la boucle à verrouillage de phase.

L'invention a pour but de ramener ce délai à deux périodes du signal synchronisant soit dans le cas présent à 128 μs au maximum, et ce par l'adjonction d'un dispositif 6 d'accélération de la synchronisation des signaux internes SIN et externe SSY. Comme illustré sur la figure 1, ce dispositif 6 reçoit en entrée d'une part le signal synchronisant SSY et, d'autre part un signal de non-coïncidence ULD, issu du comparateur de phase 4 et représentatif d'une non-coïncidence entre les transitions des signaux SIN et SSY. La sortie de ce dispositif 6 agit directement, comme on le verra ci-après plus en détail, sur la commande d'initialisation du diviseur 3.

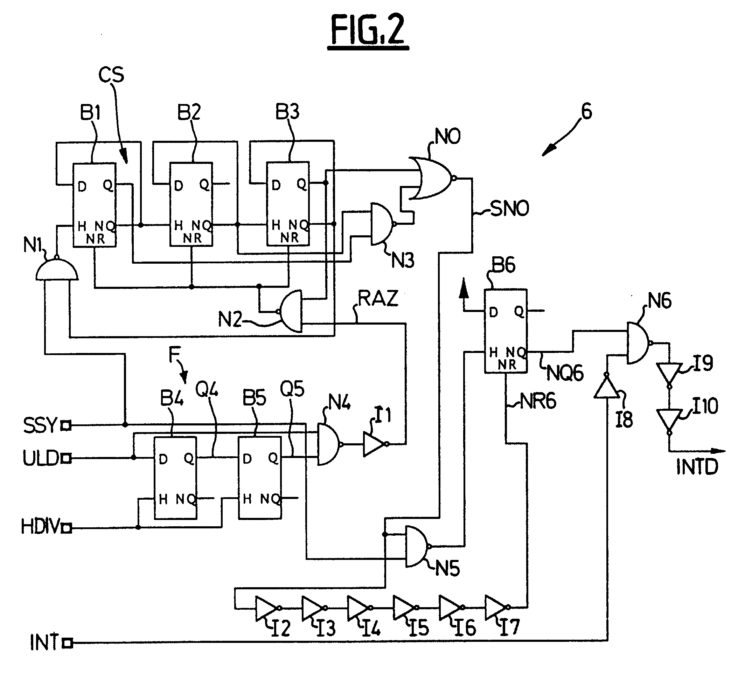

Tel qu'illustré sur la figure 2, le dispositif 6 comporte un compteur séquenceur CS formé ici de trois bascules D, référencées B1, B2, B3, et montées en cascade. Plus précisément, l'entrée D de chaque bascule est rebouclée sur la sortie complémentée NQ (ou $\overline{Q}$) de celle-ci. Par ailleurs, la sortie complémentée NQ de la première bascule B1 est reliée à l'entrée d'horloge H de la deuxième bascule B2 et la sortie complémentée NQ de cette deuxième bascule B2 est reliée à l'entrée d'horloge H de la troisième bascule B3. Ce compteur séquenceur est séquencé, comme on le verra ci-après, au rythme des transitions du signal synchronisant SSY par des moyens de séquencement comportant ici une première porte logique NON ET référencée N1 et une deuxième porte logique NON ET référencée N2. L'une des entrées de la porte N1 est reliée à l'entrée de signal synchronisant SSY tandis que l'autre entrée de cette porte N1 est reliée à la sortie complémentée NQ de la troisième bascule B3. La sortie de cette porte logique N1 est reliée à l'entrée d'horloge H de la première bascule B1.

Une entrée de la porte logique N2 est reliée à la sortie non complémentée Q de la bascule B3 tandis que l'autre entrée de cette porte logique N2 est reliée à la sortie d'un filtre F dont on reviendra plus en détail ci-après sur la structure et le fonctionnement. La sortie de cette porte logique N2 est reliée à toutes les entrées de remise à zéro NR des trois bascules B1, B2, B3 du compteur séquenceur CS.

Les moyens de traitement du dispositif 6 comportent, outre le compteur séquenceur CS, un premier ensemble logique relié à la sortie du compteur et susceptible, comme on le verra ci-après, de délivrer une impulsion de commande en réponse à une valeur de comptage prédéterminée délivrée par le compteur. Plus précisémment, ce premier ensemble logique comporte une troisième porte logique NON ET référencée N3 dont les deux entrées sont respectivement reliées aux sorties non complémentées Q et complémentées NQ des première et deuxième bascules B1 et B2. Cet ensemble logique comporte également une porte logique NON OU, référencée NO, dont les deux entrées sont respectivement reliées à la sortie de la troisième porte logique N3 et à la sortie non complémentée Q de la troisième bascule B3 du compteur séquenceur CS. La sortie de cette porte logique NO forme la sortie de ce premier ensemble logique et est susceptible de délivrer un signal logique SNO dont le passage à l'état haut représentera comme on le verra ci-après ladite impulsion de commande.

La sortie de la porte logique NON OU est reliée à une entrée d'une quatrième porte logique NON ET référencée N5, appartenant à un deuxième ensemble logique capable de délivrer, en réponse à ladite impulsion de commande émise par la porte logique NON OU, une information de commande d'initialisation du diviseur, sensiblement en coïncidence avec une transition du signal externe.

Ce deuxième ensemble logique reçoit par l'intermédiaire de l'autre entrée de la porte N5, le signal synchronisant SSY. Il comprend par ailleurs une quatrième bascule D, référencée B6, dont l'entrée D est forcée à l'état haut et dont l'entrée d'horloge H est reliée à la sortie de la porte N5. Par ailleurs, la sortie de la porte logique NON OU référencée NO est également reliée à l'entrée NR de remise à zéro de la bascule B6 par l'intermédiaire d'un circuit de retard composé ici de six inverseurs I2-I7 montés en série.

La sortie complémentée NQ de cette bascule B6 est reliée à une première entrée d'une cinquième porte logique NON ET référencée N6 dont l'autre entrée est susceptible de recevoir, par l'intermédiaire d'un inverseur I8, le signal INT d'initialisation interne du diviseur. La sortie cette porte N6 délivre, par l'intermédiaire de deux inverseurs successifs I9 et I10, le signal de commande d'initialisation INTD au diviseur 3 de la boucle.

Le filtre F comporte une cinquième bascule D référencée B4 et une sixième bascule D référencée B5 montées en cascade. L'entrée D de la bascule B4 reçoit le signal ULD issu du comparateur de phase tandis que l'entrée D de la bascule B5 est reliée à la sortie non complémentée Q de la bascule B4. Ces deux bascules sont séquencées sur leurs entrées d'horloge H par le signal d'horloge HDIV de l'oscillateur commandé en tension de la boucle.

La sortie non complémentée Q de la bascule B5 est reliée à une entrée d'une sixième porte logique NON ET référencée N4, dont l'autre entrée reçoit par ailleurs directement le signal de non coïncidence ULD non filtré. La sortie de cette porte N4 est reliée par l'intermédiaire d'un inverseur I1 à l'autre entrée de la porte logique N2.

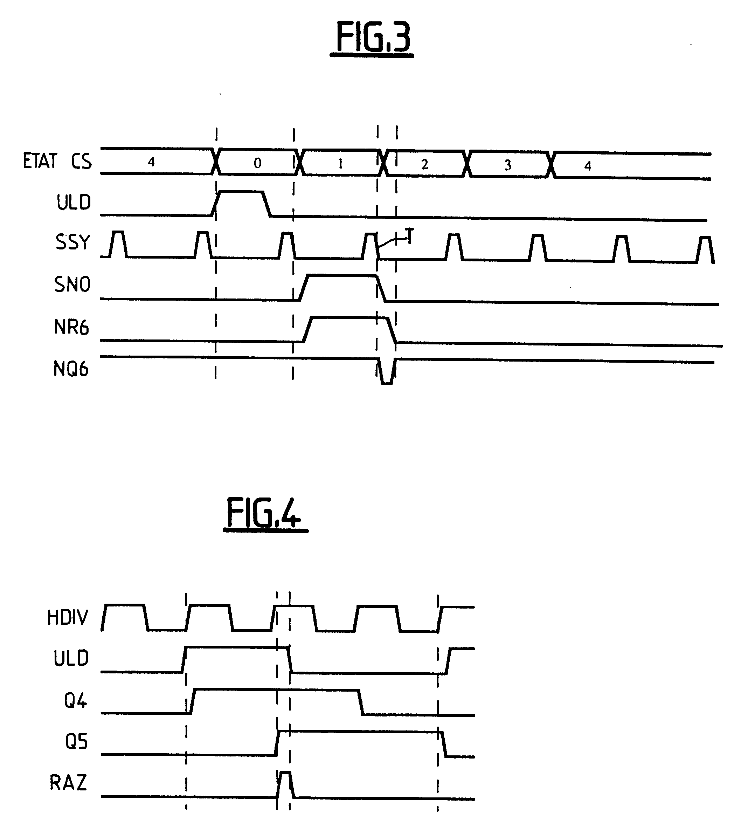

On va maintenant décrire en détail, en se référant plus particulièrement aux chronogrammes représentés sur les figures 3 et 4, le fonctionnement du dispositif accélérateur 6.

Pour l'étude de ce fonctionnement, et à des fins de simplification, les différents signaux délivrés par les sorties des bascules seront référencés avec les mêmes références que les sorties correspondantes de ces bascules, affectés en outre du numéro de la bascule. Ainsi, par exemple, le signal délivré par la sortie complémentée NQ de la bascule B2 sera affecté de la référence NQ2. De même, le signal délivré par la sortie non complémentée Q de la bascule B3 sera affecté de la référence Q3 et le signal reçu à l'entrée NR de remise à zéro de la bascule B6 sera référencé NR6.

En l'absence de signal ULD, les moyens de traitement sont dans un état de repos correspondant à une valeur de comptage égale à 4 du compteur séquenceur CS. Cette valeur de comptage correspond à un mot binaire 1 0 0 qui correspond respectivemment aux valeurs de signaux de sortie Q3, Q2 et Q1 des bascules B3, B2 et B1. Par conséquent, le signal de sortie NQ3 de la bascule B3 est à l'état bas (valeur égale à zéro). En l'absence de signal ULD, les deux entrées de la porte logique N4 sont à zéro ce qui se traduit par une sortie égale à 1 et donc une valeur du signal RAZ égale à zéro. En conséquence, la sortie de la porte logique N2 est égale à 1.

Les deux entrées de la porte logique N3 sont respectivement à 1 et à 0 ce qui a pour conséquence de mettre les deux entrées de la porte logique N0 à 1 et par conséquent la valeur du signal de sortie SNO à 0.

Puisque l'une des entrées de la porte logique N5 est à 0, sa sortie est maintenue à 1, de même que la valeur du signal NQ6 de la bascule B6.

Puisque l'une des entrées de la porte logique N1 est égale à 0 en raison de la valeur du signal de sortie NQ3 de la bascule B3, la sortie de cette porte logique N1 reste maintenue à 1. En conséquence, le compteur séquenceur reste bloqué dans cet état de repos même lors de l'apparition d'une transition du signal synchronisant, puisque l'entrée d'horloge de la bascule B1 ne change pas d'état. En conséquence, dans cet état de repos, la sortie de la porte logique N6 changera d'état au rythme des impulsions du signal d'initialisation interne du diviseur INT.

Supposons maintenant que le comparateur de phase délivre un signal de non coïncidence ULD et que celui-ci ne soit pas filtré par le filtre F. Dans ce cas, les moyens de traitement du dispositif 6 vont changer d'état et passer dans un état actif. En effet, les deux entrées de la porte logique N4 étant à 1, sa sortie passe à 0 et donc la valeur du signal RAZ est égale à 1. Puisque, de ce fait, les deux entrées de la porte logique N2 sont à 1, sa sortie passe à 0 et est appliquée aux trois entrées NR des bascules B1, B2, B3. En conséquence, les signaux de sortie Q1, Q2 et Q3 des bascules B1, B2 et B3 passent à 0 ce qui correspond à une valeur de comptage égale à zéro du compteur séquenceur CS.

En conséquence, puisque l'entrée de droite sur la figure 2 de la porte logique N1 est passée à 1 le compteur séquenceur CS va conserver cette valeur d'affichage jusqu'au front montant de la transition suivante du signal synchronisant SSY. Lors de l'occurrence de cette transition du signal SSY, le signal d'horloge de la bascule B1 passe à l'état bas (valeur 0) et va garder cette valeur jusqu'au front descendant de la transition du signal SSY. Lors de ce front descendant, le signal d'horloge de la bascule B1 repasse à l'état haut (valeur 1), et puisque les bascules B1, B2, B3 ont été choisies pour compter sur les fronts montants des signaux d'horloge, la sortie Q de cette bascule B1 passe à l'état 1, ce qui correspond à une valeur de comptage égale à 1 du compteur séquenceur, puisque les sorties Q des deux autres bascules B2 et B3 sont demeurées inchangées et égales à 0.

Dans cet état de comptage 1 du compteur séquenceur CS, les deux entrées de la porte logique N3 sont à 1 et, par conséquent, les deux entrées de la porte logique N0 sont à 0 ce qui confère la valeur 1 au signal de sortie SNO.

En conséquence, le signal d'entrée NR6 de la bascule B6 passe également à 1 avec un retard temporel dû aux inverseurs I1, I7. Cependant, la sortie de la porte logique N5 reste égale à 1 et par conséquent également le signal de sortie NQ6 de la bascule B6, puisque bien que l'entrée de la porte logique N5 recevant le signal SNO soit passée à 1, l'autre entrée de cette porte N5 est retombée à l'état bas (valeur 0) sur le front descendant de la transition du signal synchronisant SSY.

Lors du front descendant de la transition suivante du signal synchronisant SSY, le compteur séquenceur CS change à nouveau d'état indiquant cette fois-ci la valeur de comptage 2 correspondant aux valeurs 0 1 0 respectivement délivrées aux sorties Q des bascules B1, B2 et B3.

Lors du front descendant de cette transition T du signal synchronisant SSY, le signal SNO de sortie de la porte logique N0 est redescendu à l'état bas ce qui a eu pour conséquence de faire repasser à l'état haut le signal d'horloge H de la bascule B6, ce signal d'horloge étant redescendu auparavant à l'état bas lors de l'apparition du front montant de cette transition du signal synchronisant SSY. En conséquence, puisqu'on est alors en présence d'un front montant du signal d'horloge de la bascule B6, celle-ci change d'état et le signal de sortie NQ6 passe à l'état bas (valeur 0). Ce signal NQ6 garde la valeur basse jusqu'à la retombée du signal NR6 à la valeur zéro, qui se produit en retard, compte tenu des inverseur I2-I7, par rapport à la retombée du signal SNO. En conséquence, la valeur de ce retard conditionne la durée à l'état bas du signal NQ6 et donc la durée de l'impulsion de commande délivrée à la porte logique N6. Lors de cette impulsion de commande, la valeur du signal INTD est égale à 1 ce qui force la réinitialisation du diviseur de la boucle à verrouillage de phase et donc provoque une mise sensiblement en phase forcée du signal interne par l'émission d'une transition de celui-ci.

L'homme du métier remarquera que la transition forcée émise par le diviseur de l'oscillateur est donc sensiblement coïncidente avec la transition T du signal SSY qui a provoqué l'émission de l'impulsion de commande NQ6. La synchronisation des deux signaux s'effectue donc ici dans ce mode de réalisation sur les fronts descendants des transitions du signal synchronisant SSY. Cette mise en phase forcée s'est donc effectuée au bout d'un délai égal à deux périodes du signal synchronisant SSY.

Le passage du compteur séquenceur de la valeur de comptage 1 à la valeur de comptage 2 marque la fin de l'état actif des moyens de traitement et le début d'un état dit "de temporisation" dans lequel, même en présence d'une nouvelle arrivée de signal de non coïncidence ULD, aucune impulsion de commande ne sera délivrée au diviseur de l'oscillateur. La durée de temporisation a été prise égale dans ce mode de réalisation à deux périodes de signal synchronisant SSY, et a d'une façon générale pour but de ne pas perturber le fonctionnement de la boucle à verrouillage de phase qui s'est enclenché à l'issue de l'état 1 du compteur séquenceur CS.

Plus précisémment, dans ce mode de réalisation, le compteur séquenceur va après être passé dans l'état de compteur 2, indiquer, après l'occurrence de la transition suivante du signal synchronisant SSY la valeur de comptage 3 correspondant aux valeurs 1 1 0 des sorties Q des bascules B1, B2, B3. La présence d'un signal ULD pendant cet état de temporisation reste sans effet puisque l'entrée de la porte logique N2 reliée à la sortie Q de la bascule B3 reste dans cet état de temporisation à la valeur 0.

Lors de l'apparition de la transition suivant du signal de synchronisation SSY, le compteur séquenceur revient dans l'état 4 (valeur de comptage égale à 4 correspondant aux valeurs 0 0 1 des sorties Q des bascules B1, B2, B3). Il reste dans cet état si aucune nouvelle indication prédéterminée représentative de la non-coïncidence des deux signaux interne et externe n'apparaît. Par contre, en présence d'un nouveau signal de non-coïncidence ULD non filtré, le cycle recommence.

L'indication prédéterminée en réponse à laquelle le compteur séquenceur passe de l'état de comptage 4 à l'état de comptage 0, est constituée par le signal de non-coïncidence ULD filtré. En effet, il est apparu particulièrement avantageux, afin notamment de ne pas perturber le fonctionnement de la boucle de verrouillage de phase, de filtrer les brèves transitions parasites qui pourraient être émises par le comparateur de phase même lorsque les deux signaux à synchroniser sont en phase. Aussi, le filtre F a-t-il pour but de filtrer tout signal ULD ayant une durée inférieure à une période du signal d'horloge H DIV de l'oscillateur commandé en tension.

La figure 4 illustre un chronogramme temporel sur lequel on a supposé que le signal ULD avait une durée légèrement supérieure à une période du signal d'horloge HDIV. Il est à noter que les échelles temporelles de ce chronogramme sont totalement différentes de celles du chronogramme de la figure 3.

Au front montant du signal d'horloge HDIV, le signal de sortie Q4 de la bascule B4 passe à 1 et reste dans cet état pendant une durée égale à deux périodes de ce signal d'horloge H DIV. Au front montant suivant du signal d'horloge H DIV, le signal de sortie Q5 de la bascule B5 passe à l'état haut et le reste pendant deux période du signal d'horloge H DIV. Puisque le signal ULD est encore à l'état 1 lors du passage à l'état haut du signal de sortie Q5, la sortie de la porte logique N4 passe à zéro et par conséquent le signal RAZ attaquant la deuxième entrée de la porte logique N2 passe à l'état 1. Ce signal RAZ a conservé la valeur 1 jusqu'au front descendant du signal ULD.

Si par contre le signal ULD avait une durée inférieure à une période du signal d'horloge, c'est-à-dire si son front descendant était apparu avant la montée du signal Q5 à l'état 1, la sortie de la porte logique N4 serait restée à 1 et par conséquent le signal de sortie RAZ serait resté à la valeur zéro ce qui n'aurait pas provoqué le passage des moyens de traitement de leur état de repos à leur état actif.

## Revendications

1. Procédé pour favoriser l'activation d'une boucle à verrouillage de phase, dans lequel

   a) on compare (4) la phase du signal externe reçu (SSY) et celle du signal interne (SIN) tiré du signal de sortie de l'oscillateur commandé en tension (2) de la boucle (1), et
   b) en réponse à une indication prédéterminée (RAZ) représentive d'une non-coïncidence de phase entre les deux signaux, on modifie la phase du signal interne (SIN) afin de forcer la mise sensiblement en phase de celui-ci avec le signal externe (SSY), caractérisé par le fait que, après avoir forcé la mise en phase des deux signaux à synchroniser, on inhibe toute action sur les moyens de génération du signal interne pendant une durée prédéterminée, même en présence d'une autre indication représentative d'une non-coïncidence, et on répète ensuite l'étape b) en présence d'une nouvelle indication prédéterminée représentative d'une non-coïncidence de phase.

2. Procédé selon la revendication 1, dans lequel la boucle comporte un diviseur (3), relié à la sortie de l'oscillateur (2) commandé en tension, et apte à délivrer ledit signal interne (SIN), caractérisé par le fait qu'en présence de ladite indication prédéterminée (ULD, RAZ) on réinitialise le diviseur pour forcer une quasi coïncidence entre une transition du signal interne (SIN) et une transition du signal externe (SSY).

3. Procédé selon l'une des revendications précédentes, caractérisé par le fait que l'on fait délivrer par le comparateur de phase (4) un signal de non coïncidence (ULD) représentatif d'une non-coïncidence de phase entre les deux signaux, et par le fait que l'on filtre (F) le signal de non-coïncidence (ULD), ladite indication prédéterminée (RAZ) étant la valeur du signal de non-coïncidence filtré.

4. Procédé selon la revendication 3, caractérisé par le fait que l'on filtre tout signal de non-coïncidence (ULD) ayant une durée inférieure à une période du signal d'horloge (HDIV) de l'oscillateur commandé en tension.

5. Procédé selon l'une des revendications précédentes, caractérisé par le fait que l'on agit sur les moyens de génération (3) du signal interne (SIN) dans un délai au plus égal sensiblement à deux périodes du signal externe (SSY).

6. Boucle à verrouillage de phase, comprenant des moyens (3) de génération d'un signal interne (SIN) tiré du signal de sortie de l'oscillateur (2) commandé en tension, un comparateur de phase (4) apte à comparer la phase du signal interne (SIN) avec celle d'un signal externe reçu (SSY) et dont la sortie est rebouclée sur l'oscillateur (2) commandé en tension, et un dispositif (6) accélérateur de la synchronisation des signaux interne et externe, comportant des moyens de traitement aptes à recevoir du comparateur de phase (4) une indication prédéterminée (ULD, RAZ) représentative de la non-coïncidence des signaux interne et externe, et à délivrer, en réponse à cette indication prédéterminée, une information de commande (INTD) en réponse à laquelle les moyens de génération (3) modifient la phase du signal interne pour forcer la mise sensiblement en phase de ce dernier avec le signal externe (SSY), caractérisée par le fait que les moyens de traitement possèdent un état de repos en l'absence d'indication prédéterminée (ULD, RAZ) émanant du comparateur (4), un état actif dans lequel, en présence d'une indication prédéterminée (ULD, RAZ), ils délivrent l'information de commande aux moyens de génération du signal interne, et un état de temporisation dans lequel ils sont inactifs vis-à-vis de la commande des moyens de génération, même en présence d'une nouvelle indication prédéterminée émanant du comparateur de phase,

et par le fait que le dispositif comporte des moyens de séquencement (N1, N2) aptes à faire passer les moyens de traitement de leur état de repos à leur état actif puis à leur état de temporisation et à leur état de repos au rythme des transitions du signal externe (SSY).

7. Boucle selon la revendication 6, caractérisée par le fait que les moyens de génération comportent un diviseur (3) disposé entre la sortie de l'oscillateur (2) commandé en tension et une entrée du comparateur de phase (4), pour délivrer ledit signal interne (SIN) formé d'une succession périodique de transitions,

par le fait que l'information de commande est un signal de commande (INTD) d'initialisation du diviseur (3) émis sensiblement en coïncidence avec une transition (T) du signal externe, le diviseur (3) émettant alors en réponse une transition du signal interne sensiblement en coïncidence avec ladite transition (T) du signal externe.

8. Boucle selon la revendication 6 ou 7, caractérisée par le fait que les moyens de traitement comportent :

- un compteur séquenceur (CS), séquencé au rythme des transitions du signal externe (SSY), et susceptible de délivrer cycliquement un jeu de valeurs de comptage différentes (4, 0, 1, 2, 3) associées aux différents états des moyens de traitement,

- un premier ensemble logique (N3, NO) relié à la sortie du compteur (CS) et susceptible de délivrer une impulsion de commande (SNO) en réponse à une valeur de comptage (1) prédéterminée associée à l'état de travail,

- un deuxième ensemble logique (N5, I2, I7, B6, N6) relié d'une part à la sortie du premier ensemble logique et d'autre part à l'entrée de signal externe (SSY), pour délivrer, en réponse à ladite impulsion de commande (SNO), ladite information de commande (INTD) sensiblement en coïncidence avec une transition (T) du signal externe (SSY).

9. Boucle selon la revendication 8, caractérisée par le fait que le compteur séquenceur (CS) comporte trois bascules D (B1, B2, B3) montées en cascade, dont les entrées (D) sont respectivement rebouclées sur les sorties complémentées correspondantes (NQ) et dont l'entrée d'horloge (H) d'une bascule est reliée à la sortie complémentée (NQ) de la bascule précédente,

- par le fait que les moyens de séquencement comportent une première porte logique NON ET (N1) dont une entrée est reliée à l'entrée de signal externe (SSY), dont une autre entrée est reliée à la sortie complémentée (NQ) de la troisième bascule (B3) et dont la sortie est reliée à l'entrée d'horloge (H) de la première bascule (B1),

- une deuxième porte logique NON ET (N2) dont la sortie est reliée aux entrées (NR) de remise à zéro des bascules (B1, B2, B3), dont une entrée est reliée à la sortie non complémentée (Q) de la troisième bascule (B3) et dont l'autre entrée est susceptible de recevoir ladite indication prédéterminée (RAZ).

10. Boucle selon la revendication 9, caractérisée par le fait que le premier ensemble logique comporte une troisième porte logique NON ET (N3) dont les deux entrées sont respectivement reliées aux sorties non complémentées (Q) et complémentées (NQ) des première et deuxième bascules (B1, B2),

et une porte logique NON OU (NO) dont les deux entrées sont respectivement reliées à la sortie de la troisième porte logique NON ET (N3) et à la sortie non complémentée (Q) de la troisième bascule (B3), la sortie de la porte logique NON OU (NO) étant la sortie de ce premier ensemble logique.

11. Boucle selon l'une des revendications 8 à 10, caractérisée par le fait que le deuxième ensemble logique comporte une quatrième porte logique NON ET (N5) dont une entrée est reliée à la sortie du premier ensemble logique, et dont l'autre entrée est reliée à l'entrée de signal externe (SSY),

une quatrième bascule (B6) dont l'entrée d'horloge (H) est reliée à la sortie de la quatrième porte logique (N5) et dont l'entrée de remise à zéro (NR) est reliée à la sortie du premier ensemble logique par un circuit de retard (I2-I7), une cinquième porte logique NON ET (N6) dont une entrée est reliée à la sortie de la quatrième bascule (P6) et dont l'autre entrée est susceptible de recevoir une impulsion (INT) émanant des moyens d'initialisation interne du diviseur (3).

12. Boucle selon l'une des revendications 6 à 11, caractérisée par le fait que le comparateur de phase (4) est susceptible de délivrer un signal (ULD) de non-coïncidence de phase des signaux interne (SIN) et externe (SSY),

et par le fait que le dispositif (6) comporte un filtre (F) apte à filtrer les signaux de non-coïncidence ayant une durée inférieure à une durée prédéterminée, ladite indication prédéterminée (RAZ) étant la valeur du signal de non-coïncidence filtrée.

13. Boucle selon la revendication 12, caractérisée par le fait que le filtre (F) comporte une cinquième et une sixième bascules (B4, B6), montées en cascade, l'entrée (D) de la cinquième bascule (B4) recevant le signal de non-coïncidence, l'entrée (D) de la sixième bascule (B5) étant reliée à la sortie non complémentée de la cinquième bascule (B4), les entrées d'horloge (HD) de ces deux bascules étant cadencées par le signal d'horloge (HDIV) de l'oscillateur commandé en tension (3),

et une sixième porte logique NON ET (N4), dont une entrée reçoit le signal de non-coïncidence (ULD) et dont l'autre entrée est reliée à la sortie de la sixième bascule (B5) la sortie de cette sixième porte logique (N4) étant reliée à l'autre entrée de la deuxième porte logique (N2) des moyens de séquencement.

14. Boucle selon l'une des revendications 6 à 13, caractérisée par le fait que l'oscillateur est à faible variation de fréquence, par exemple un oscillateur à quartz.

15. Dispositif d'accélération de synchronisation appartenant à la boucle à verrouillage de phase telle que définie dans l'une des revendications 6 à 14.

**Patentansprüche**

1. Verfahren zur Begünstigung der Aktivierung einer Phasenregelschleife, bei dem

(a) die Phase eines extern empfangenen Signals (SSY) und die eines internen Signals (SIN), das vom Ausgangssignal des spannungsgesteuerten Oszillators (2) der Regelschleife (1) abgegriffen wird, miteinander verglichen werden (4), und
(b) im Ansprechen auf eine vorbestimmte Anzeige (RAZ), die eine fehlende Phasenkoinzidenz zwischen den beiden Signalen anzeigt, die Phase des internen Signals (SIN) verändert wird, um dessen Einstellung auf eine im wesentlichen gleiche Phase zu dem externen Signal (SSY) zu erzwingen,

**dadurch gekennzeichnet, daß**

nach der erzwungenen Phasenlageeinstellung der beiden zu synchronisierenden Signale jegliche Einwirkung auf die Einrichtungen zur Erzeugung des internen Signals während einer vorbestimmten Dauer verhindert ist, und zwar selbst bei Vorliegen einer anderen eine fehlende Phasenkoinzidenz anzeigenden Anzeige, und daß dann, bei Vorliegen einer neuen vorbestimmten Anzeige, die eine fehlende Phasenkoinzidenz anzeigt, der Schritt b) wiederholt wird.

2. Verfahren nach Anspruch 1, bei dem die Regelschleife einen an den Ausgang des spannungsgesteuerten Oszillators (2) angeschlossenen Teiler (3) aufweist, der zur Ausgabe des internen Signals (SIN) geeignet ist,
**dadurch gekennzeichnet, daß**
bei Vorliegen der vorbestimmten Anzeige (ULD, RAZ) der Teiler erneut initialisiert wird, um eine Quasi-Koinzidenz zwischen einem Übergang des internen Signals (SIN) und einem Übergang des externen Signals (SSY) zu erzwingen.

3. Verfahren nach einem der vorhergehenden Ansprüche,
**dadurch gekennzeichnet, daß**
der Phasenvergleicher (4) ein Signal (ULD) bezüglich der fehlenden Koinzidenz ausgibt, welches das Fehlen einer Phasenkoinzidenz zwischen den beiden Signalen anzeigt, und daß das Signal bezüglich der fehlenden Koinzidenz (ULD) einer Filterung (F) unterzogen wird, wobei die vorbestimmte Anzeige (RAZ) den Wert des gefilterten Signals bezüglich der fehlenden Koinzidenz hat.

4. Verfahren nach Anspruch 3,
**dadurch gekennzeichnet, daß**
jedes Signal bezüglich der fehlenden Koinzidenz (ULD) mit einer Dauer, die kleiner als eine Periode des Taktsignals (HDIV) des spannungsgesteuerten Oszillators ist, gefiltert wird.

5. Verfahren nach einem der vorhergehenden Ansprüche,
**dadurch gekennzeichnet, daß**

während einer Dauer von maximal etwa zwei Perioden des externen Signals (**SSY**) eine Einwirkung auf die Einrichtungen (**3**) zur Erzeugung des internen Signals (**SSI**) erfolgt.

6. Phasenregelschleife, mit

einer Einrichtung (**3**) zur Erzeugung eines internen Signals (**SIN**), das vom Ausgangssignal des spannungsgesteuerten Oszillators (**2**) abgegriffen wird,
einem Phasenvergleicher (**4**), der geeignet ist, um die Phase des internen Signals (**SIN**) mit der eines extern empfangenen Signals (**SSY**) zu vergleichen, und dessen Ausgang zu dem spannungsgesteuerten Oszillator (**2**) rückgekoppelt ist, und
einer Vorrichtung (**6**) zur Beschleunigung der Synchronisation der internen und externen Signale, die Verarbeitungseinrichtungen umfaßt, welche geeignet sind, um von dem Phasenvergleicher (**4**) eine das Fehlen der Koinzidenz des internen und des externen Signals darstellende, vorbestimmte Anzeige (**ULD, RAZ**) zu empfangen und im Ansprechen auf diese vorbestimmte Anzeige eine Steuerungsinformation (**INTD**) auszugeben, wobei die Erzeugungseinrichtung (**3**) im Ansprechen auf diese die Phase des internen Signals verändert, um die Einstellung des letzteren auf eine im wesentlichen gleiche Phase zu dem externen Signal (**SSY**) zu erzwingen,

**dadurch gekennzeichnet, daß**
die Verarbeitungseinrichtungen

einen Ruhezustand bei Fehlen der von dem Vergleicher (**4**) stammenden vorbestimmten Anzeige (**ULD, RAZ**), und
einen Aktivzustand bei Vorliegen einer vorbestimmten Anzeige (**ULD, RAZ**) haben, in dem sie Steuerungsinformationen an die Einrichtung zur Erzeugung des internen Signals abgeben, sowie
einen Verzögerungszustand haben, in dem sie hinsichtlich der Steuerung der Erzeugungseinrichtung selbst bei Vorliegen einer von dem Phasenvergleicher stammenden neuen vorbestimmten Anzeige inaktiv sind, und dadurch, daß die Vorrichtung Einrichtungen (**N1**, **N2**) zum sequentiellen Ordnen aufweist, die geeignet sind, um im Rhythmus der Übergänge des externen Signals (**SSY**) einen Zustandsübergang der Verarbeitungseinrichtungen aus deren Ruhezustand in deren Aktivzustand und dann in deren Verzögerungszustand und deren Ruhezustand zu bewirken.

7. Phasenregelschleife nach Anspruch 6,
**dadurch gekennzeichnet, daß**

die Erzeugungseinrichtung einen zwischen dem Ausgang des spannungsgesteuerten Oszillators (**2**) und einem Eingang des Phasenvergleichers (**4**) angeordneten Teiler (**3**) aufweist, um das interne Signal (**SIN**) in Form einer periodischen Folge von Übergängen auszugeben, und
es sich bei den Steuerungsinformationen um ein Steuerungssignal (**INTD**) zur Initialisierung des Teilers (**3**) handelt, das im wesentlichen gleichzeitig mit einem Übergang (**T**) des externen Signals ausgegeben wird, woraufhin der Teiler (**3**) dann im Ansprechen darauf einen Übergang des internen Signals bewirkt, der im wesentlichen gleichzeitig mit dem Übergang (**T**) des externen Signals auftritt.

8. Phasenregelschleife nach Anspruch 6 oder 7,
**dadurch gekennzeichnet, daß**
die Verarbeitungseinrichtungen

- einen im Rhythmus der Übergänge des externen Signals (**SSY**) betriebenen Befehlsgeberzähler (**CS**) aufweisen, der geeignet ist, zyklisch einen Satz von unterschiedlichen Zählwerten (4, 0, 1, 2, 3) auszugeben, die den unterschiedlichen Zuständen der Verarbeitungseinrichtung zugeordnet sind,
- eine mit dem Ausgang des Zählers (**CS**) verbundene erste Logikanordnung (**N3**, **N0**) aufweisen, die geeignet ist, im Ansprechen auf einen dem Arbeitszustand zugeordneten vorbestimmten Zählwert (1) einen Steuerungsimpuls (**SNO**) abzugeben,
- eine einerseits mit dem Ausgang der ersten Logikanordnung und andererseits mit dem Eingang des externen Signals (**SSY**) verbundene zweite Logikanordnung (**N5**, **I2**, **I7**, **B6**, **N6**) aufweisen, um im Ansprechen auf den Steuerungsimpuls (**SNO**) die Steuerungsinformation (**INTD**) im wesentlichen gleichzeitig mit einem Übergang (**T**) des externen Signals (**SSY**) abzugeben.

9. Phasenregelschleife nach Anspruch 8,
**dadurch gekennzeichnet, daß**
der Befehlsgeberzähler (**CS**) drei in Reihe geschaltete D-Kippglieder (**B1**, **B2**, **B3**) umfaßt, deren Eingänge (**D**) jeweils auf die entsprechenden komplementären Ausgänge (**NQ**) rückgekoppelt sind, und wobei der Takteingang (**H**) eines Kippgliedes mit dem komplementären Ausgang (**NQ**) des vorhergehenden Kippgliedes verbunden ist, und daß

- die Einrichtungen zum sequentiellen Ordnen ein erstes Logikgatter des NAND-Typs (**N1**) umfassen, dessen einer Eingang mit dem Eingang des externen Signals (**SSY**) und dessen anderer Eingang mit dem komplementären Ausgang (**NQ**) des dritten Kippgliedes (**B3**) und dessen Ausgang mit dem Takteingang (**H**) des ersten Kippgliedes (**B1**) verbunden ist, und

- ein zweites Logikgatter des NAND-Typs (**N2**) umfassen, dessen Ausgang mit den Rücksetzeingängen (**NR**) der Kippglieder (**B1**, **B2**, **B3**) verbunden ist, dessen einer Eingang mit dem nicht-komplementären Ausgang (**Q**) des dritten Kippgliedes (**B3**) verbunden ist und dessen anderer Eingang geeignet ist, um die vorbestimmte Anzeige (**RAZ**) zu empfangen.

10. Phasenregelschleife nach Anspruch 9,
   **dadurch gekennzeichnet, daß**

   die erste Logikanordnung ein drittes Logikgatter des NAND-Typs (**N3**) aufweist, dessen beide Eingänge jeweils mit dem nicht-komplementären Ausgang (**Q**) und dem komplementären Ausgang (**NQ**) des ersten und des zweiten Kippgliedes (**B1**, **B2**) verbunden sind, und ein Logikgatter des NOR-Typs (**NO**) aufweist, dessen beide Eingänge jeweils mit dem Ausgang des dritten Logikgatters des NAND-Typs (**N3**) und dem nicht-komplementären Ausgang (**Q**) des dritten Kippgliedes (**B3**) verbunden ist, wobei der Ausgang des Logikgatters des NOR-Typs (**NO**) den Ausgang der ersten Logikanordnung bildet.

11. Phasenregelschleife nach einem der Ansprüche 8 bis 10,
   **dadurch gekennzeichnet, daß**
   die zweite Logikanordnung ein viertes Logikgatter des NAND-Typs (**N5**) aufweist, dessen einer Eingang mit dem Ausgang der ersten Logikanordnung verbunden ist, und dessen anderer Eingang mit dem Eingang des externen Signals (**SSY**) verbunden ist,

   ein viertes Kippglied (**B6**) aufweist, dessen Takteingang (**H**) mit dem Ausgang des vierten Logikgatters (**N5**) verbunden ist und dessen Rücksetzeingang (**NR**) über eine Verzögerungsschaltung (**I2-I7**) mit dem Ausgang der ersten Logikanordnung verbunden ist, ein fünftes Logikgatter des NAND-Typs (**N6**) aufweist, dessen einer Eingang mit dem Ausgang des vierten Kippgliedes (**B6**) verbunden ist und dessen anderer Eingang geeignet ist, um einen von den Einrichtungen zur internen Initialisierung des Teilers (**3**) stammenden Impuls (**INT**) zu empfangen.

12. Phasenregelschleife nach einem der Ansprüche 6 bis 11,
   **dadurch gekennzeichnet, daß**

   der Phasenvergleicher (**4**) geeignet ist, um ein Signal (**ULD**) der fehlenden Koinzidenz der Phase des internen Signals (**SIN**) und des externen Signals (**SSY**) abzugeben, und die Vorrichtung (**6**) ein Filter (**F**) aufweist, das geeignet ist, die Signale der fehlenden Koinzidenz einer eine vorbestimmte Dauer unterschreitenden Dauer zu filtern, wobei die vorbestimmte Anzeige (**RAZ**) den Wert des gefilterten Signals der fehlenden Koinzidenz hat.

13. Phasenregelschleife nach Anspruch 12,
   **dadurch gekennzeichnet, daß**

   das Filter (**F**) ein fünftes und ein sechstes Kippglied (**B4**, **B5**) umfaßt, die in Reihe geschaltet sind, wobei der Eingang (**D**) des fünften Kippgliedes (**B4**) das Signal der fehlenden Koinzidenz empfängt, der Eingang (**D**) des sechsten Kippgliedes (**B5**) mit dem nicht-komplementären Ausgang des fünften Kippgliedes (**B4**) verbunden ist und die Takteingänge (**H**) der beiden Kippglieder durch das Taktsignal (**HDIV**) des spannungsgesteuerten Oszillators (**3**) getaktet sind, und ein sechstes Logikgatter des NAND-Typs (**N4**) aufweist, dessen einer Eingang das Signal der fehlenden Koinzidenz (**ULD**) empfängt und dessen anderer Eingang mit dem Ausgang des sechsten Kippgliedes (**B5**) verbunden ist, wobei der Ausgang dies sechsten Logikgatters (**N4**) mit dem anderen Eingang des zweiten Logikgatters (**N2**) der Einrichtungen zum sequentiellen Ordnen verbunden ist.

14. Phasenregelschleife nach einem der Ansprüche 6 bis 13,
   **dadurch gekennzeichnet, daß**
   der Oszillator nur geringe Frequenzschwankungen hat und beispielsweise ein Quarz-Oszillator ist.

15. Vorrichtung zur Synchronisationsbeschleunigung, die auf einer Phasenregelschleife gemäß einem der Ansprüche 6 bis 14 beruht.

**Claims**

1. Method for promoting activation of a phase-locked loop, in which

   a) the phase of the external signal received (SSY) is compared (4) with that of the internal signal (SIN) drawn from the output signal of the voltage-controlled oscillator (2) of the loop (1), and

b) in response to a predetermined indication (ZR) representative [sic] of phase non-coincidence between the two signals, the phase of the internal signal (SIN) is modified so as to force the latter substantially into phase with the external signal (SSY), characterized in that, after having forced the two signals to be synchronized into phase, any action on the means of generating the internal signal is inhibited for a predetermined duration, even in the presence of another indication representing a non-coincidence, and step b) is then repeated in the presence of a new predetermined indication representative of a phase non-coincidence.

2. Method according to Claim 1, in which the loop includes a divider (3), linked to the output of the voltage-controlled oscillator (2), and able to deliver the said internal signal (SIN), characterized in that, in the presence of the said predetermined indication (ULD, ZR) the divider is reinitialized in order to force a quasi-coincidence between one transition of the internal signal (SIN) and a transition of the external signal (SSY).

3. Method according to one of the preceding claims, characterized in that the phase comparator (4) is made to deliver a non-coincidence signal (ULD) representative of a phase non-coincidence between the two signals, and in that the non-coincidence signal (ULD) is filtered (F), the said predetermined indiction (ZR) being the value of the filtered non-coincidence signal.

4. Method according to Claim 3, characterized in that any non-coincidence signal (ULD), having a duration less than one period of the clock signal (HDIV) of the voltage-controlled oscillator, is filtered.

5. Method according to one of the preceding claims, characterized in that the means (3) of generating the internal signal (SIN) are acted upon in a time scale at most equal substantially to two periods of the external signal (SSY) .

6. Phase-locked loop, comprising means (3) of generating an internal signal (SIN) drawn from the output signal of the voltage-controlled oscillator (2), a phase comparator (4) able to compare the phase of the internal signal (SIN) with that of an external signal received (SSY) and the output of which is looped back onto the voltage-controlled oscillator (2), and a device (6) accelerating the synchronization of the internal and external signals, including processing means able to receive, from the phase comparator (4), a predetermined indication (ULD, ZR) representative of the non-coincidence of the internal and external signals, and, in response to this predetermined indication, to deliver control information (INTD) in response to which the generation means (3) modify the phase of the internal signal in order to force the latter substantially into phase with the external signal (SSY), characterized in that the processing means possess a rest state in the absence of predetermined indication (ULD, ZR) originating from the comparator (4), an active state in which, in the presence of a predetermined indication (ULD, ZR), they deliver the control information to the means of generating the internal signal, and a time delay state in which they are inactive with respect to the control of the generation means, even in the presence of a new predetermined indication originating from the phase comparator,

and in that the device includes sequencing means (N1, N2) able to make the processing means pass from their rest state to their active state then to their time delay state and to their rest state in time with the transitions of the external signal (SSY).

7. Loop according to Claim 6, characterized in that the generation means include a divider (3) arranged between the output of the voltage-controlled oscillator (2) and one input of the phase comparator (4), in order to deliver the said internal signal (SIN) formed by a periodic succession of transitions,

in that the control information is a control signal (INTD) for initialization of the divider (3), sent substantially in coincidence with a transition (T) of the external signal, the divider (3) then, in response, sending a transition of the internal signal substantially in coincidence with the said transition (T) of the external signal.

8. Loop according to Claim 6 or 7, characterized in that the processing means include:

- a sequencer counter (CS), sequenced in time with the transitions of the external signal (SSY), and capable of cyclically delivering a set of different count values (4, 0, 1, 2, 3) associated with the different states of the processing means,
- a first logic assembly (N3, N0) linked to the output of the counter (CS) and capable of delivering a control pulse (SNO) in response to a predetermined count value (1) associated with the working state,
- a second logic assembly (N5, I2, I7, B6, N6) linked, on the one hand, to the output of the first logic assembly and, on the other hand, to the external signal input (SSY) in order, in response to the said control pulse (SNO), to deliver the said control information (INTD) substantially in coincidence with a transition (T) of the external signal (SSY).

9.  Loop according to Claim 8, characterized in that the sequencer counter (CS) includes three D-type flip-flops (B1, B2, B3) mounted in cascade, the inputs (D) of which are respectively lopped back onto the corresponding complemented outputs (NQ), and in which the clock input (H) of a flip-flop is linked to the complemented output (NQ) of the preceding flip-flop,

    - in that the sequencing means include a first NAND logic gate (N1), one input of which is linked to the external signal input (SSY), another input of which is linked to the complemented output (NQ) of the third flip-flop (B3), and the output of which is linked to the clock input (H) of the first flip-flop (B1),
    - a second NAND logic gate (N2), the output of which is linked to the zero-reset inputs (NR) of the flip-flops (B1, B2, B3), one input of which is linked to the non-complemented output (Q) of the third flip-flop (B3) and the other input of which is capable of receiving the said predetermined indication (ZR).

10. Loop according to Claim 9, characterized in that the first logic assembly includes a third NAND logic gate (N3), the two inputs of which are linked respectively to the non-complemented (Q) and complemented (NQ) outputs of the first and second flip-flops (B1, B2),

    and a NOR logic gate (NO), the two inputs of which are linked respectively to the output of the third NAND logic gate (N3) and to the non-complemented output (Q) of the third flip-flop (B3), the output of the NOR logic gate (NO) being the output of this first logic assembly.

11. Loop according to one of Claims 8 to 10, characterized in that the second logic assembly includes a fourth NAND logic gate (N5), one input of which is linked to the output of the first logic assembly, and the other input of which is linked to the external signal input (SSY),

    a fourth flip-flop (B6), the clock input (H) of which is linked to the output of the fourth logic gate (N5) and the zero-reset (NR) input of which is linked to the output of the first logic assembly by a delay circuit (I2-I7), a fifth NAND logic gate (N6), one input of which is linked to the output of the fourth flip-flop (P6) [sic] and the other input of which is capable of receiving a pulse (INT) originating from the internal initialization means of the divider (3).

12. Loop according to one of Claims 6 to 11, characterized in that the phase comparator (4) is capable of delivering a signal (ULD) of phase non-coincidence of the internal (SIN) and external (SSY) signals,

    and in that the device (6) includes a filter (F) able to filter the non-coincidence signals having a duration less than a predetermined duration, the said predetermined indication (ZR) being the filtered value of the non-coincidence signal.

13. Loop according to Claim 12, characterized in that the filter (F) includes a fifth and a sixth flip-flop (B4, B6) mounted in cascade, the input (D) of the fifth flip-flop (B4) receiving the non-coincidence signal, the input (D) of the sixth flip-flop (B5) being linked to the non-complemented output of the fifth flip-flop (B4), the clock inputs (HD) of these two flip-flops being clocked by the clock signal (HDIV) of the voltage-controlled oscillator (3),

    and a sixth NAND logic gate (N4), one input of which receives the non-coincidence signal (ULD) and the other input of which is linked to the output of the sixth flip-flop (B5), the output of this sixth logic gate (N4) being linked to the other input of the second logic gate (N2) of the sequencing means.

14. Loop according to one of Claims 6 to 13, characterized in that the oscillator is an oscillator with a small frequency variation, for example a quartz oscillator.

15. Synchronization acceleration device belonging to the phase-locked loop as defined in one of Claims 6 to 14.

# FIG.1

# FIG.2

## FIG.3

## FIG.4